# FASCICULE DE BREVET EUROPEEN

(11) **EP 4 095 935 B1**
(45) Date de publication et mention de la délivrance du brevet: **26.06.2024**
(21) Numéro de dépôt: 22175394.0
(22) Date de dépôt: 25.05.2022
(51) Int. Cl.: G11C 13/00, H10N 70/00, H10N 70/20

(54) **PROCÉDÉ DE FABRICATION D'UNE MÉMOIRE À CHANGEMENT DE PHASE**
HERSTELLUNGSVERFAHREN EINES SPEICHERS MIT PHASENÄNDERUNG
METHOD OF FABRICATION OF A PHASE-CHANGING MEMORY

(30) Priorité: 28.05.2021 FR 2105618
(43) Date de publication de la demande: 30.11.2022
(73) Titulaire: STMicroelectronics (Crolles 2) SAS, 38920 Crolles (FR)
(72) Inventeur: GOURAUD, Pascal, 38330 Montbonnot St Martin (FR); FAVENNEC, Laurent, 38190 Villard Bonnot (FR)
(74) Mandataire: Cabinet Beaumont

(56) Documents cités:
- US-A1- 2009 101 883
- US-A1- 2018 358 547
- US-A1- 2019 131 348
- US-A1- 2020 044 148
- US-A1- 2020 098 989

## Description

### Domaine technique

La présente description concerne de façon générale les dispositifs électroniques et plus particulièrement les mémoires à changement de phase et leur procédé de fabrication.

### Technique antérieure

Les matériaux à changement de phase sont des matériaux qui peuvent basculer, sous l'effet de la chaleur, entre une phase cristalline et une phase amorphe. Comme la résistance électrique d'un matériau amorphe est significativement supérieure à la résistance électrique d'un matériau cristallin, ce phénomène peut être utile pour définir deux états de mémoire, par exemple 0 et 1, différenciés par la résistance mesurée à travers le matériau à changement de phase.

Les cellules mémoire sont de préférence agencées, dans une mémoire, sous forme de matrice comprenant des lignes, associées par exemple à des lignes de mot, et des colonnes, associées par exemple à des lignes de bit.

Les documents US 2020/098989 A1, US 2018/358547 A1, US 2019/131348 A1, US 2009/101883 A1 et US 2020/044148 A1 divulguent des méthodes de formation des cellules mémoire magnétique comprenant une couche en matériau à changement de phase par gravure.

### Résumé de l'invention

Un mode de réalisation prévoit un procédé de fabrication d'une cellule mémoire selon la revendication indépendante 1

Selon un mode de réalisation, l'étape a) comprend la formation d'au moins une troisième couche isolante électriquement entre la deuxième couche et le premier masque.

Selon un mode de réalisation, l'étape c) ne grave pas au même instant la première couche et une autre couche en un autre matériau.

Selon un mode de réalisation, le procédé comprend la formation d'un élément résistif en contact avec la première couche.

Selon un mode de réalisation, le procédé de gravure utilisé pour les gravures de la quatrième couche grave le matériau de la quatrième couche au moins vingt fois plus rapidement que le matériau de la couche située sous la quatrième couche.

Selon un mode de réalisation, le premier masque est en nitrure de titane.

Selon un mode de réalisation, la première couche est en un alliage de germanium, d'antimoine et de tellure.

Selon un mode de réalisation, le procédé comprend la fabrication d'une matrice de cellules mémoire, chaque cellule étant fabriquée par un procédé selon l'une quelconque des revendications 1 à 7.

Selon un mode de réalisation, un premier masque est formé sur l'emplacement de chaque cellule mémoire, et dans lequel l'étape c) est effectuée simultanément pour toutes les cellules.

Selon un mode de réalisation, chaque premier masque est commun à une ligne de cellules de de la matrice, et dans lequel chaque deuxième masque est commun à une colonne de cellules de la matrice.

Selon un mode de réalisation, le procédé comprend le dépôt d'au moins une couche isolante électriquement sur les cellules de la matrice.

Selon un mode de réalisation, le procédé comprend la formation de vias conducteurs électriquement traversant la couche isolante de manière à atteindre la deuxième couche.

Selon un mode de réalisation, le procédé comprend la formation d'une bande conductrice s'étendant sur les deuxièmes couches des cellules d'une ligne ou d'une colonne de la matrice.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre une étape d'un mode réalisation d'un procédé de fabrication d'une cellule mémoire à changement de phase ;
la figure 2 illustre une autre étape d'un mode réalisation d'un procédé de fabrication d'une cellule mémoire à changement de phase ;
la figure 3 illustre une autre étape d'un mode réalisation d'un procédé de fabrication d'une cellule mémoire à changement de phase ;
la figure 4 illustre une autre étape d'un mode réalisation d'un procédé de fabrication d'une cellule mémoire à changement de phase ;
la figure 5 illustre une autre étape d'un mode réalisation d'un procédé de fabrication d'une cellule mémoire à changement de phase ;
la figure 6 illustre une autre étape d'un mode réalisation d'un procédé de fabrication d'une cellule mémoire à changement de phase ;
la figure 7 illustre une autre étape d'un mode réalisation d'un procédé de fabrication d'une mémoire à changement de phase ;
la figure 8 illustre une autre étape d'un mode réalisation d'un procédé de fabrication d'une mémoire à changement de phase ;
la figure 9 illustre une étape alternative à l'étape de la figure 8 ; et
la figure 10 illustre une étape alternative aux étapes des figures 8 et 9.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas" , "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

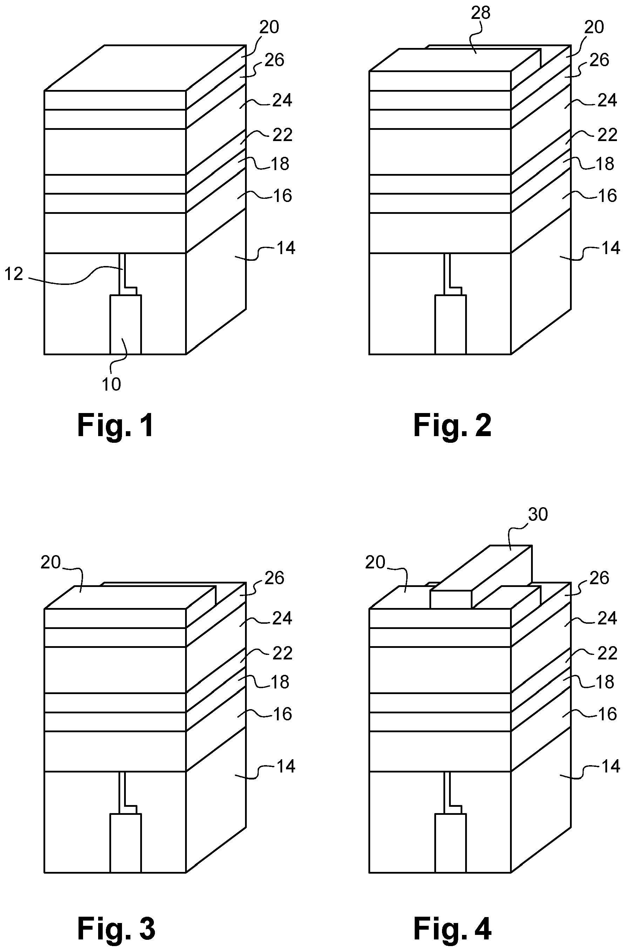

Les figures 1 à 8 illustrent des étapes, de préférence successives, d'un mode réalisation d'un procédé de fabrication d'une mémoire à changement de phase.

La figure 1 illustre une étape d'un mode réalisation d'un procédé de fabrication d'une cellule mémoire à changement de phase.

Cette étape de fabrication comprend la formation d'un via conducteur 10. Cette étape comprend la fabrication d'un élément résistif 12, reposant sur le via conducteur 10. L'élément résistif 12 a, de préférence, une forme de L, une partie horizontale reposant sur le via 10 et une partie verticale s'étendent sensiblement perpendiculairement à la partie horizontale. Le via 10 et l'élément résistif 12 sont entourés par une couche 14 isolante électriquement. Une face supérieure de la partie verticale de l'élément résistif 12 affleure une face supérieure de la couche 14. La couche 14 comprend par exemple un empilement de plusieurs couches isolantes électriquement, par exemple en des matériaux isolants électriquement différents.

La couche 14, et la face supérieure de la partie verticale de l'élément résistif, sont recouverts par un empilement de couches comprenant :
- une couche 16 en un matériau à changement de phase ;
- une couche 18 conductrice ;
- un masque de gravure (hard mask) 20.

La couche 16 est une couche plane recouvrant la face supérieure de la partie verticale de l'élément résistif 12 et recouvre, de préférence entièrement, la couche 14. La couche 16 est ainsi en contact avec la couche 14. La couche 16 est de préférence en un alliage GST de germanium, d'antimoine et de tellure. La couche 18 est par exemple en nitrure de titane.

Le masque 20 est une couche s'étendant de préférence sur toute la couche 18. Le masque 20 est par exemple en un métal ou un alliage métallique, par exemple en nitrure de titane.

Le masque 20 et la couche 18 sont par exemple séparés par une ou plusieurs couches, par exemple des couches isolantes, formant un masque de gravure. Dans l'exemple de la figure 1, le masque 20 et la couche 18 sont séparés par :
- une couche 22 isolante électriquement, par exemple en nitrure de silicium ;
- une couche 24, par exemple en un matériau isolant électriquement, par exemple en carbone amorphe ; et
- une couche 26 en un matériau antiréflexif pour lithographie, par exemple un matériau isolant électriquement, par exemple en oxyde de silicium.

La figure 2 illustre une autre étape d'un mode réalisation d'un procédé de fabrication d'une cellule mémoire à changement de phase.

Au cours de cette étape, une bande 28 est formée sur le masque 20. La bande 28 correspond par exemple à un masque de photolithographie.

La bande 28 recouvre l'emplacement de la cellule mémoire. La bande 28 s'étend dans une première direction, par exemple dans le sens d'une ligne de la matrice de cellules mémoire. La bande 28 recouvre par exemple les emplacements de plusieurs cellules, par exemple de toutes les cellules de la ligne de la matrice. Dans une direction orthogonale à la direction de la ligne, correspondant par exemple à la direction d'une colonne de la matrice, la bande 28 ne recouvre l'emplacement que d'une cellule mémoire.

La figure 3 illustre une autre étape d'un mode réalisation d'un procédé de fabrication d'une cellule mémoire à changement de phase.

Au cours de cette étape, les parties du masque 20 non recouvertes par la bande 28 sont gravées. La gravure est de préférence une gravure sélective du matériau du masque 20 par rapport au matériau de la couche située sous le masque 20, par exemple le matériau de la couche 26. De préférence, le procédé de gravure grave le matériau de la couche 20 au moins 20 fois plus vite que le matériau de la couche 26. De préférence, uniquement le masque 20 est gravé durant cette étape. De préférence, les couches 18, 22, 24 et 26 ne sont pas gravées durant cette étape. La couche 16 n'est pas gravée durant cette étape.

La bande 28 est ensuite retirée.

La figure 4 illustre une autre étape d'un mode réalisation d'un procédé de fabrication d'une cellule mémoire à changement de phase.

Au cours de cette étape une bande 30 est formée sur le masque 20. La bande 30 correspond par exemple à un masque de photolithographie.

La bande 30 recouvre l'emplacement de la cellule mémoire. La bande 30 s'étend dans une deuxième direction, par exemple sensiblement orthogonale à la première direction, par exemple dans le sens d'une colonne de la matrice de cellules mémoire. La bande 30 recouvre par exemple les emplacements de plusieurs cellules, par exemple de toutes les cellules de la colonne de la matrice. Dans une direction orthogonale à la direction de la colonne, correspondant par exemple à la direction d'une ligne de la matrice, la bande 30 ne recouvre l'emplacement que d'une cellule mémoire.

La bande 30 recouvre la partie du masque 20 située à l'emplacement de la cellule mémoire. De préférence, la bande 30 recouvre uniquement la partie du masque 20 située sur l'emplacement de la cellule mémoire. La bande 30 recouvre par exemple une partie de la couche 26.

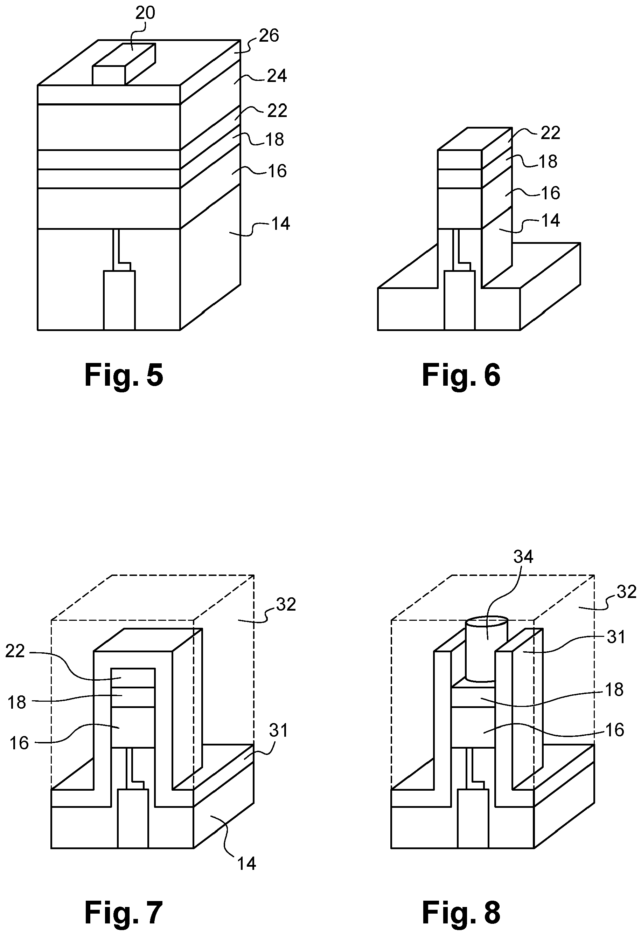

La figure 5 illustre une autre étape d'un mode réalisation d'un procédé de fabrication d'une cellule mémoire à changement de phase.

Au cours de cette étape, les parties du masque 20 non recouvertes par la bande 30 sont gravées. La gravure est de préférence une gravure sélective du matériau du masque 20 par rapport au matériau de la couche située sous le masque 20, par exemple le matériau de la couche 26. De préférence, uniquement le masque 20 est gravé durant cette étape. De préférence, les couches 18, 22, 24 et 26 ne sont pas gravées durant cette étape. La couche 16 n'est pas gravée durant cette étape.

La bande 30 est ensuite retirée.

Le masque 20 obtenu à la suite de l'étape de la figure 5 est de préférence un parallélépipède rectangle.

Les étapes des figures 2 à 5 permettent de former le masque 20 recouvrant l'emplacement de la cellule mémoire. Le masque 20 est ainsi en regard de l'emplacement de la cellule mémoire, de préférence uniquement en regard de l'emplacement de la cellule mémoire.

A titre de variante, les étapes des figures 2 à 5 peuvent être remplacées par la formation d'un masque remplaçant les masques 28 et 30, et recouvrant uniquement l'emplacement de la cellule mémoire et la gravure de la couche de masque 20. La formation du masque 20 ne comprend alors qu'une seule gravure de la couche de masque 20.

La figure 6 illustre une autre étape d'un mode réalisation d'un procédé de fabrication d'une cellule mémoire à changement de phase.

Cette étape comprend la gravure autour du masque 20 des couches 26, 18 et 16, ainsi que des couches séparant la couche 18 et le masque 20, ici les couches 22, 24 et 26. Cette étape peut aussi comprendre la gravure partielle de la couche 14 autour de la cellule mémoire.

Les couches de l'empilement, c'est-à-dire les couches 16, 18, 22, 24 et 26, sont des couches planes s'étendant, de manière plane autour de la cellule mémoire, par exemple dans tout l'emplacement de la matrice de cellules mémoire. En particulier, la couche 16 en matériau à changement de phase s'étend de manière continue entre les différentes cellules mémoire de la matrice. Ainsi, lors de l'étape de gravure de l'empilement, c'est-à-dire l'étape de la figure 6, les matériaux des différentes couches ne sont pas gravés simultanément. En particulier, le matériau de la couche 16 n'est pas gravé en même temps que le matériau des autres couches de l'empilement.

Au moins certaines des couches situées au-dessus de la couche 18 sont aussi retirées. Dans l'exemple de la figure 6, les couches 24, 26 et 20 sont retirées de l'emplacement de la cellule mémoire.

On aurait pu choisir de former une cellule mémoire par un procédé comprenant :
- une première gravure de l'empilement, y compris la couche 16 en matériau à changement de phase, de manière à séparer les lignes de la matrice les unes des autres ;
- un dépôt d'une couche ou plusieurs couche isolantes électriquement, en particulier entre les lignes de la matrice ; et
- une deuxième gravure de l'empilement, y compris la couche 16 en matériau à changement de phase, de manière à séparer les colonnes de la matrice les unes des autres. La couche 16 serait alors gravée en même temps que le matériau isolant électriquement formé au niveau de la couche 16 entre les lignes. La gravure simultanée du matériau à changement de phase et d'un autre matériau, en particulier un matériau isolant électriquement, peut altérer le matériau à changement de phase et diminuer l'efficacité de la cellule mémoire.

La figure 7 illustre une autre étape d'un mode réalisation d'un procédé de fabrication d'une mémoire à changement de phase.

Cette étape comprend le dépôt conforme d'une couche de passivation 31. La couche 31 est par exemple en un matériau isolant électriquement, par exemple en nitrure de silicium. La couche de passivation 31 recouvre les parois des couches 14, 16, 18 et 22 découvertes par la gravure de l'étape de la figure 6. La couche 31 recouvre la face supérieure de la cellule mémoire, ici la face supérieure de la couche 22.

Cette étape comprend, de plus, la formation d'une couche 32 représentée, en transparence, par des pointillés. La couche 32 est en un matériau isolant électriquement, par exemple en oxyde de silicium.

Les figures 8 à 10 illustrent trois modes de réalisation distincts d'une étape de fabrication d'un contact, ou électrode, supérieur de la cellule.

La figure 8 illustre une autre étape d'un mode réalisation d'un procédé de fabrication d'une mémoire à changement de phase. Plus précisément, la figure 8 représente la formation d'un via conducteur 34. Cette étape est de préférence effectuée après l'étape de la figure 7.

Cette étape comprend la formation d'une cavité s'étendant depuis la face supérieure de la couche 32 jusqu'à la couche 18 et le remplissage de cette cavité avec un matériau conducteur, par exemple un métal. La cavité est gravée à travers la couche 32, la couche de passivation 31, et la couche 22 de manière à atteindre la couche conductrice 18. Les vias 34 des cellules d'une même ligne ou d'une même colonne de la matrice de cellules sont par exemple reliés par une bande conductrice non représentée, reposant par exemple sur la face supérieure de la couche 32.

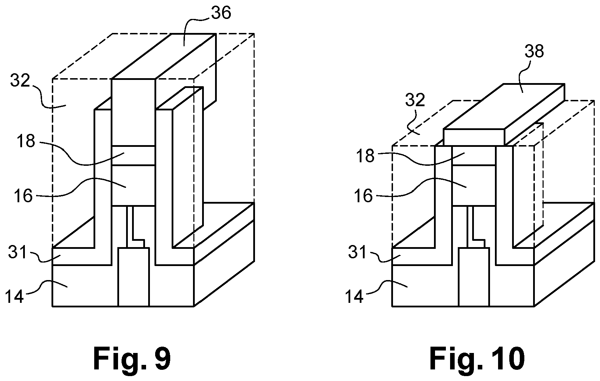

La figure 9 illustre une étape alternative à l'étape de la figure 8. Autrement dit, cette étape est effectuée à la place de l'étape de la figure 8, à la suite de l'étape de la figure 7. Plus précisément, la figure 9 représente la formation d'une bande conductrice 36 reliant les cellules d'une même ligne ou d'une même colonne.

Au cours de cette étape, une cavité est gravée dans la couche 32 et dans les couches 31 et 22 des cellules reliées par la bande 36. La cavité s'étend donc depuis la face supérieure de la couche 32 jusqu'à la couche 18. La cavité traverse donc, dans la cellule mémoire, la couche 22 et la couche 31. Entre les cellules mémoire, la cavité s'étend dans la couche 31. La cavité est ensuite remplie par un matériau conducteur, par exemple un métal.

La figure 10 illustre une étape alternative aux étapes des figures 8 et 9. Autrement dit, cette étape est effectuée à la place de l'étape de la figure 8 ou 9, à la suite de l'étape de la figure 7. Plus précisément, la figure 10 représente la formation d'une bande conductrice 38 reliant les cellules d'une même ligne ou d'une même colonne de la matrice mémoire.

Au cours de cette étape, la couche 32, la couche 31 et la couche 22 sont gravées de manière plane jusqu'à découvrir la face supérieure de la couche 18. Une couche plane en un matériau conducteur, par exemple un métal, est ensuite formée sur la structure obtenue après la gravure. La couche recouvre ainsi, la face supérieure de la couche 18 et des faces supérieures des couches 31 et 32 autour de la cellule mémoire. La couche conductrice est ensuite gravée de manière à conserver une bande s'étendant, dans la première direction, sur les couches 18 de plusieurs cellules. Dans une deuxième direction, la bande 38 s'étend par exemple sur toute la couche 18 et partiellement sur la face supérieure de la couche 31.

Les modes de réalisation sont décrits pour la fabrication d'une seule cellule mémoire. Les procédés peuvent être utilisés pour fabriquer simultanément une pluralité de cellules, par exemple une matrice de cellules mémoire. Le procédé comprend alors la formation d'un masque 20 recouvrant chaque emplacement d'une cellule mémoire et la gravure simultanée de l'empilement de couches autour des emplacements des cellules mémoire, c'est-à-dire la gravure des parties de l'empilement non recouvertes par les masques 20.

Un avantage des modes de réalisation décrits est que la couche en matériau à changement de phase n'est pas gravée en même temps qu'un autre matériau.

Un autre avantage des modes de réalisation décrits est que les procédés décrits comprennent une étape de gravure et des étapes de dépôt de couches par rapport aux procédés connus.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Procédé de fabrication d'une cellule mémoire comprenant :
a) la formation d'un empilement (16, 18, 22, 24, 26) comprenant une première couche (16) en un matériau à changement de phase et une deuxième couche (18) conductrice ;
b) la formation d'un premier masque (20) sur l'empilement recouvrant uniquement l'emplacement de la cellule mémoire ;
c) la gravure des parties de l'empilement non recouvertes par le premier masque (20),
l'étape b) comprenant :
- le dépôt d'une quatrième couche (20) en le matériau du premier masque sur l'empilement ;
- la formation d'un deuxième masque (28) s'étendant dans une première direction et recouvrant l'emplacement de la cellule mémoire ;
- la gravure des parties de la quatrième couche (20) non recouvertes par le deuxième masque (28) ;
- la formation d'un troisième masque (30) s'étendant dans une deuxième direction et recouvrant l'emplacement de la cellule mémoire ;
- la gravure des parties de la quatrième couche (20) non recouvertes par le troisième masque.

2. Procédé selon la revendication 1, dans lequel l'étape a) comprend la formation d'au moins une troisième couche isolante électriquement (22, 24, 26) entre la deuxième couche (18) et le premier masque (20).

3. Procédé selon la revendication 1 ou 2, dans lequel l'étape c) ne grave pas au même instant la première couche (16) et une autre couche en un autre matériau.

4. Procédé selon l'une quelconque des revendications 1 à 3, comprenant la formation d'un élément résistif (12) en contact avec la première couche (16).

5. Procédé selon l'une quelconque des revendications 1 à 4, dans lequel le procédé de gravure utilisé pour les gravures de la quatrième couche grave le matériau de la quatrième couche au moins vingt fois plus rapidement que le matériau de la couche (28) située sous la quatrième couche (20).

6. Procédé selon l'une quelconque des revendications 1 à 5, dans lequel le premier masque (20) est en nitrure de titane.

7. Procédé selon l'une quelconque des revendications 1 à 6, dans lequel la première couche (16) est en un alliage de germanium, d'antimoine et de tellure.

8. Procédé de fabrication d'une mémoire, comprenant la fabrication d'une matrice de cellules mémoire, chaque cellule étant fabriquée par un procédé selon l'une quelconque des revendications 1 à 7.

9. Procédé selon la revendication 8, dans lequel un premier masque (20) est formé sur l'emplacement de chaque cellule mémoire, et dans lequel l'étape c) est effectuée simultanément pour toutes les cellules.

10. Procédé selon la revendication 8 ou 9, dans lequel chaque deuxième masque (28) est commun à une ligne de cellules de la matrice, et dans lequel chaque troisième masque (30) est commun à une colonne de cellules de la matrice.

11. Procédé selon l'une quelconque des revendications 8 à 10, comprenant le dépôt d'au moins une couche isolante électriquement (31, 32) sur les cellules de la matrice.

12. Procédé selon la revendication 11, comprenant la formation de vias (34) conducteurs électriquement traversant la couche isolante (31, 32) de manière à atteindre la deuxième couche.

13. Procédé selon l'une quelconque des revendications 8 à 11, comprenant la formation d'une bande conductrice (36, 38) s'étendant sur les deuxièmes couches des cellules d'une ligne ou d'une colonne de la matrice.

## Patentansprüche

1. Verfahren zum Herstellen einer Speicherzelle, aufweisend:
(a) Ausbilden eines Stapels (16, 18, 22, 24, 26), der eine erste Schicht (16) aus einem Phasenwechselmaterial und eine zweite, leitende Schicht (18) aufweist;
(b) Ausbilden einer ersten Maske (20) auf dem Stapel, die nur den Speicherzellenplatz abdeckt; und
(c) Ätzen von Teilen des Stapels, die nicht von der ersten Maske (20) bedeckt sind,
wobei Schritt b) Folgendes aufweist:
- Abscheiden einer vierten Schicht (20) des ersten Maskenmaterials auf dem Stapel;
- Ausbilden einer zweiten Maske (28), die sich in einer ersten Richtung erstreckt und den Speicherzellenplatz abdeckt;
- Ätzen von Teilen der vierten Schicht (20), die nicht von der zweiten Maske (28) bedeckt sind;
- Ausbilden einer dritten Maske (30), die sich in einer zweiten Richtung erstreckt und den Speicherzellenplatz abdeckt;
- Ätzen der nicht von der dritten Maske bedeckten Teile der vierten Schicht (20).

2. Verfahren nach Anspruch 1, wobei Schritt a) das Ausbilden mindestens einer dritten, elektrisch isolierenden Schicht (22, 24, 26) zwischen der zweiten Schicht (18) und der ersten Maske (20) aufweist.

3. Verfahren nach Anspruch 1 oder 2, wobei in Schritt c) die erste Schicht (16) und eine weitere Schicht aus einem anderen Material nicht gleichzeitig geätzt werden.

4. Verfahren nach einem der Ansprüche 1 bis 3, aufweisend das Ausbilden eines Widerstandselements (12) in Kontakt mit der ersten Schicht (16).

5. Verfahren nach einem der Ansprüche 1 bis 4, wobei das für das Ätzen der vierten Schicht verwendete Ätzverfahren das Material der vierten Schicht mindestens zwanzigmal schneller ätzt als das unter der vierten Schicht (20) befindliche Schichtmaterial (28).

6. Verfahren nach einem der Ansprüche 1 bis 5, wobei die erste Maske (20) aus Titannitrid besteht.

7. Verfahren nach einem der Ansprüche 1 bis 6, wobei die erste Schicht (16) aus einer Legierung aus Germanium, Antimon und Tellur besteht.

8. Verfahren zum Herstellen eines Speichers, aufweisend das Herstellen eines Arrays von Speicherzellen, wobei jede Zelle durch ein Verfahren nach einem der Ansprüche 1 bis 7 hergestellt wird.

9. Verfahren nach Anspruch 8, wobei eine erste Maske (20) über dem Ort jeder Speicherzelle gebildet wird und wobei der Schritt c) für alle Zellen gleichzeitig durchgeführt wird.

10. Verfahren nach Anspruch 8 oder 9, wobei jede erste Maske (28) einer Zeile von Zellen in dem Array gemeinsam ist, und wobei jede zweite Maske (30) einer Spalte von Zellen in dem Array gemeinsam ist.

11. Verfahren nach einem der Ansprüche 8 bis 10, aufweisend das Abscheiden mindestens einer elektrisch isolierenden Schicht (31, 32) auf den Zellen des Arrays.

12. Verfahren nach Anspruch 11, aufweisend das Abscheiden von elektrisch leitenden Durchkontaktierungen (34) durch die isolierende Schicht (31, 32) hindurch, so dass sie die zweite Schicht erreichen.

13. Verfahren nach einem der Ansprüche 8 bis 11, aufweisend das Ausbilden einer leitenden Bahn (36, 38), die sich über die zweiten Schichten von Zellen in einer Zeile oder Spalte des Arrays erstreckt.

## Claims

1. A method for manufacturing a memory cell comprising:
(a) forming a stack (16, 18, 22, 24, 26) comprising a first layer (16) of a phase change material and a second conductive layer (18);
(b) forming a first mask (20) on the stack covering only the memory cell location; and
(c) etching portions of the stack not covered by the first mask (20),
step b) comprising:
- depositing a fourth layer (20) of the first mask material on the stack;
- forming a second mask (28) extending in a first direction and covering the memory cell location;
- etching portions of the fourth layer (20) not covered by the second mask (28);
- forming a third mask (30) extending in a second direction and covering the memory cell location;
- etching the portions of the fourth layer (20) not covered by the third mask.

2. The method according to claim 1, wherein step a) comprises forming at least a third electrically insulating layer (22, 24, 26) between the second layer (18) and the first mask (20).

3. The method according to claim 1 or 2, wherein step c) does not etch the first layer (16) and another layer of another material at the same time.

4. The method according to any of claims 1 to 3, comprising forming a resistive element (12) in contact with the first layer (16) .

5. The method according to any of claims 1 to 4, wherein the etching method used for the fourth layer etchings etches the material of the fourth layer at least twenty times faster than the layer material (28) located below the fourth layer (20).

6. The method according to any of claims 1 to 5, wherein the first mask (20) is titanium nitride.

7. The method according to any of claims 1 to 6, wherein the first layer (16) is of a germanium, antimony and tellurium alloy.

8. A method for manufacturing a memory, comprising manufacturing an array of memory cells, each cell being manufactured by a method according to any of claims 1 to 7.

9. The method according to claim 8, wherein a first mask (20) is formed over the location of each memory cell, and wherein step c) is performed simultaneously for all cells.

10. The method according to claim 8 or 9, wherein each first mask (28) is common to a line of cells in the array, and wherein each second mask (30) is common to a column of cells in the array.

11. The method according to any of claims 8 to 10, comprising depositing at least one electrically insulating layer (31, 32) on the cells of the array.

12. The method according to claim 11 comprising depositing electrically conductive vias (34) through the insulating layer (31, 32) so as to reach the second layer.

13. The method according to any of claims 8 to 11, comprising forming a conductive band (36, 38) extending over the second layers of cells in a line or column of the array.
